# EUROPEAN PATENT APPLICATION

(11) **EP 1 775 758 A2**
(43) Date of publication of application: **18.04.2007**
(21) Application number: 05766467.4
(22) Date of filing: 25.07.2005
(51) Int. Cl.: H01L 21/26

(54) **SILICON WAFER SUBSTRATE LOCKING STAGE AND SILICON WAFER SUBSTRATE TEMPERATURE MEASURING METHOD**

(30) Priority: 23.07.2004 JP 2004215957
(71) Applicant: Intellectual Property Bank Corp., 1-21-19, Toranomon, Minato-ku Tokyo 1050001 (JP); T.P.S. System Co., Ltd., Shinagawa-ku Tokyo 1420052 (JP); ICF Inc., Minami-ku, Kyoto-shi Kyoto 6018206 (JP)
(72) Inventor: MURAKAMI, Yukihiro c/o IP Bank Corp., Minato-ku, Tokyo 1050001 (JP); ASANO, Kazuo c/o T.P.S. System Co., Ltd., Tokyo 1420052 (JP); OKAMOTO, Ryuji c/o ICF Inc., Kyoto 6018206 (JP)
(74) Representative: Sunderland, James Harry
(86) International application number: PCT/JP2005/013559
(87) International publication number: WO 2006/009278

(57) **Abstract**

In order to measure the temperature of an object to be processed that has a high infrared transparency in a lamp-heater-equipped chamber filled with an erosive gas, the following measures are taken. A groove is formed in a stage for holding a single silicon wafer substrate attached on the top of a lamp heater or in an enclosure made from quartz and the like provided on a light emitting open section side of the lamp heater so that a thermocouple to be embedded does not contact the erosive gas. To address the issue described above, an equivalent of an object to be processed, namely a small piece of a silicon wafer substrate, is bonded to the thermocouple. Prior to temperature measurement, the difference between a measured temperature of a silicon wafer substrate to be measured placed on the surface of the stage and a measured temperature of the small silicon wafer piece is measured. The difference in thermal capacity between the silicon wafer substrate and the silicon wafer substrate piece is corrected. Using the apparatus and method, the temperature of the silicon wafer substrate can be measured.

## Description

### Technical Field

The present invention relates to a stage for holding a silicon wafer substrate that includes a lamp heater below the stage and has the capability of measuring the temperature of the silicon wafer substrate in a noncontacting manner.

A stage according to the present invention holds a silicon wafer substrate without contacting the silicon wafer substrate, thereby enabling continuous measurement of the temperature at least one point on the silicon wafer substrate.

### Background Art

There have been contact measurement methods using a thermocouple and contactless measurement methods using a radiation thermometer as techniques for measuring the temperature of silicon wafer substrates.

A typical temperature measuring method using a thermocouple is described in Patent Document 3 and therefore description thereof will be omitted herein. Patent Document 1 particularly discloses a method of disposing a thermocouple on a stage.

Patent Document 1 describes a method for providing a temperature-programmed desorption analyzer that makes the controlled temperature of the surface of a sample equal to that of a thermocouple in which at least the top of a sample stage is made from a highly thermal conductive material and a thermocouple and the surface of the sample are brought into contact with the sample stage to heat the sample stage through heat conduction to reduce the difference in temperature between the sample stage and the thermocouple. An embodiment of the method is described in Patent Document 1 in which the top and bottom of the sample stage are made from quartz and an infrared lamp is used to heat the stage. In another method for directly measuring the temperature of a silicon wafer, a thermocouple is provided on the tip of each of pins of a silicon wafer that pierce the stage in such a manner that they are capable of moving vertically, as described in Patent Document 2.

Another method is to use a dummy wafer on which a thermocouple are provided in contact with the wafer (Patent Documents 4 and 5). However, this method is impractical because it is difficult to correct the difference in temperature between a wafer to be processed and the dummy wafer.

None of these contact measuring methods using thermocouples according to the conventional techniques has been capable of readily moving a measurement point.

The contacted measuring methods using a radiation thermometer also have a problem. Conventional radiation thermometers used in a stage equipped with a heater for heating silicon wafer substrates must detect a certain infrared ray because silicon wafer substrates are infrared-transparent. Therefore, an infrared-transparent window made from fluorite is required, which is not only expensive but also causes contamination with Ca produced due to decomposition of the fluorite in an environment in which the fluorite is exposed to highly corrosive vapor.

The method described in Patent Document 1 has a problem that a temperature monitoring thermocouple is heated by transmitted infrared radiation to a temperature higher than that of a sample because the thermocouple senses infrared radiation transmitted through the infrared-transparent quartz.
The method described in Patent Document 2 requires that the thermocouple should be in contact with a silicon wafer all the time in order to measure the temperature of the silicon wafer substrate. Accordingly, there is friction at contacts between the thermocouple and the silicon wafer due to a difference in thermal expansion between them when temperature rises and drops. The friction causes contamination and particles which can decrease yields.
It is extremely difficult to measure an object to be processed that has a high infrared transparency in a lamp-heater-equipped chamber filled with an erosive gas.

First, there is a problem caused by characteristics of lamp heaters. Lamp heaters have the characteristic of irradiating an object to be processed with light emitted from a light source to heat the object. Because of the characteristic of heating with light, heat generated may vary depending on light reception characteristics of objects to be processed. For example, a semiconductor wafer and aluminum plate generate different amount of heat in response to the same amount of light, therefore they have different temperatures. In particular, when a semiconductor wafer to be processed placed in an aluminum chamber is irradiated with light from a heating lamp, the temperature of the semiconductor wafer differs from that of the aluminum chamber. Therefore, measuring the temperature of the aluminum chamber does not mean measuring the temperature of the semiconductor wafer.

Second, there is a problem that it is practically impossible to perform measurement using an infrared thermometer. It may be conceivable that an infrared thermometer can be used to directly measure the temperature of the semiconductor wafer in order to solve the first problem that the temperature of the semiconductor wafer differs from that of the aluminum chamber as described above. However, it was revealed that the temperature of the semiconductor wafer cannot be measured with an infrared thermometer because the semiconductor wafer has high infrared transparency.

Third, there is a problem of the influences of erosive gas. Since an infrared thermometer cannot be used, thermocouples must be used for measurement. However, again, temperatures measured with thermocouples attached to the chamber do not indicate the temperature of the semiconductor wafer because of the first problem described above. On the other hand, measuring the temperature of an object to be processed with a thermocouple directly attached to the object involves attaching and detaching the thermocouples each time processing is performed, which is unfavorable and unrealistic for the field where high processing speeds are required. Furthermore, it is problematic that the thermocouples are exposed to the erosive gas environment in the chamber and therefore are damaged very early. Also, the thermocouples react with the gas to produce particles, which attach to and contaminate an object to be processed.

Fourth, the surface of an obj ect to be measured can change during processing and with this change the surface thermal emissivity of the semiconductor wafer can change, therefore an error can be caused if temperature conversion is performed using a fixed thermal emissivity. The thermal emissivity can drastically vary from approximately 0.2 to 0.8 in an extreme case. As a result, an error of as large as 10% can result at 1,000°C.

[Patent Document 1]: Japanese Patent Application Publication No. 2000-045838
[Patent Document 2]: Japanese Patent Application Publication No. 08-172392
[Patent Document 3]: Japanese Patent No. 3468300
[Patent Document 4]: Japanese Patent No. 3663035 ... Dummy wafer dotted with recesses
[Patent Document 5]: Japanese Patent No. 2984060 ... Wafer substrate having inside elongated cavities

### Disclosure of the Invention

An object of the present invention is to propose a temperature measuring method that overcomes drawbacks of conventional contact measuring methods using thermocouples and contacted measuring methodsusing radiation thermometers.

The present invention proposes a temperature measuring method that effectively uses thermocouples and proposes a stage that implements the measuring method. The stage according to the present invention is as described below.

At least one thermocouple having a piece of silicon attached to its back facing a silicon wafer substrate for sensing temperature is embedded in a stage for holding the silicon wafer substrate attached on the top of a lamp heater in such a manner that the thermocouple is not in contact with the silicon wafer substrate. The temperature of the piece of silicon is measured and the difference in time-varying temperature between the silicon wafer substrate and the piece of silicon due to the difference in thermal mass between the silicon wafer substrate and the piece of silicon is obtained in advance. The obtained difference is used to correct the difference between the silicon wafer substrate and the piece of silicon in time-varying temperature and the temperature of the silicon wafer substrate is measured.

### Effects of the Invention

According to the present invention, a silicon wafer substrate stage can be provided that is capable of holding a silicon wafer and has the capability of sensing the temperature of the silicon wafer substrate without being affected by a lamp heater and without contacting the silicon wafer substrate and ozone gas.

By linearly disposing in a cavity multiple thermocouples equipped with a piece of silicon wafer having the same composition as that of a silicon wafer substrate whose temperature is to be measured in an opposite direction to the silicon wafer substrate, information on one-dimensional temperatures of the silicon wafer can be directly and simultaneously obtained. Based on this data, the temperature distribution over the surface of the silicon wafer can be estimated and information about a heater can be excluded to obtain the temperature of a more accurate reaction field at a low cost.

The inventive method can be used for temperature measurement of reaction systems using gasses and chemicals that do not erode quartz and therefore can find wide application.

Using the present invention, temperature can be detected without causing contamination.

Furthermore, a groove is provided in a stage for holding a silicon wafer substrate attached on the top of a lamp heater or an enclosure made from quartz or the like provided on a light-emitting open section side of the lamp heater so that a thermocouple to be embedded is not in contact with an erosive gas. In order to address the first problem described above, an equivalent of an object to be processed is attached to the thermocouple. If the object to be processed is a semiconductor wafer, the thermocouple is attached to a small piece of semiconductor wafer.
A device which has a thermocouple attached to a cutout of an equivalent of an object to be processed is embedded in a lamplight-transparent material such as a stage made from quartz in this way, so that the thermocouple receives the same amount of light that the object to be processed receives and generates a temperature equal to the temperature of the object. Thus, the temperature of the object can be measured through a wire attached to the thermocouple.

In addition, the embedded device structure prevents the device from being affected by an erosive gas or from spattering particles in a process room.

### Brief Description of the Drawings

Fig. 1 is a top view of a silicon wafer substrate stage having the capability of observing temperature according to an embodiment of the present invention.
Fig. 2 is a cross-sectional view of the silicon wafer substrate stage having the capability of observing temperature according to the embodiment of the present invention, taken perpendicularly to a line passing through the center of a cavity 2.
Fig. 3 is a top view of the silicon wafer stage having the capability of observing temperature according to the embodiment of the present invention and an enlarged view of the cavity, showing an overview of connection between a PFA (registered trademark) tube for protecting a thermocouple and a Teflon (registered trademark) joint.
Fig. 4 is a cross-sectional view of a structure that holds a silicon wafer including a temperature observation capability on a silicon wafer substrate stage having a temperature observation capability according to a first embodiment of the present invention so that temperature correction can be performed, taken perpendicularly to a line passing through the center of the cavity 2 of the silicon wafer substrate stage.
Fig. 5 is a top view of a silicon wafer substrate stage having a one-dimensional temperature observation capability according to a second embodiment of the present invention.
Fig. 6 is a top view of a silicon wafer substrate stage having a two-dimensional temperature observation capability according to a third embodiment of the present invention, cut at the half depth of thermocouples.
Fig. 7 is a cross-sectional view of the silicon wafer substrate stage having the two dimensional temperature observation capability according to the third embodiment of the present invention, taken long line A - A'.
Fig. 8 shows an example of results of actual measurement of the temperatures of a silicon wafer substrate and a piece of a silicon wafer according to an implementation of the present invention.
Fig. 9 shows an example of results of actual measurement of the temperature of a silicon wafer substrate according to an implementation of the present invention.

### Description of Symbols

- 1: Silicon wafer substrate stage
- 2: Rectangular parallelepiped cavity
- 3: Piece of a silicon wafer
- 4: Thermocouple
- 5: Polyimide adhesive
- 6: Thermocouple lead
- 7: Silicon wafer support
- 8: silicon wafer holding notch
- 9: Silicon wafer
- 10: Teflon (registered trademark) joint
- 11: PFA (registered trademark) tube
- 12: O-ring
- 13: Quartz wool
- 14: Pen recorder
- 15: Terminal
- 16: Lamp heater

### Best Mode for Carrying out the Invention

While embodiments of the present invention will be described below, the present invention is not limited to the embodiments.
In order to attach a thermocouple of the present invention, a rectangular parallelepiped cavity (155 mm long x 5 mm wide x 5 mm high) is provided that extends linearly in parallel to a disc-shaped stage made from quartz of 310 mm in diameter and 8 mm in thickness from one point on a side of the stage. A k-thermocouple K104 from TECH-JAM Co., LTD. is bonded on the front side of a silicon wafer substrate piece that is 3 mm long, 3 mm wide, and 0.76 mm thick and has the same composition and thickness as those of a silicon wafer substrate to be measured by using 0.5 cc of a polyimide adhesive. After the polyimide adhesive is thermoset, the thermocouple is placed in the center of the cavity in such a manner that the thermocouple on the front side of the silicon wafer substrate piece faces the side opposite to a lamp heater. Leads of the thermocouple are connected to predetermined terminals of a 302323 pen recorder from Yokogawa Electric Corporation which is placed in a predetermined place.

The space in the cavity that is not occupied by the thermocouple with the silicon wafer substrate piece is filled with quartz wool. For the purpose of guiding the leads of the thermocouple with the silicon wafer substrate piece, a Teflon (registered trademark) joint is tightly attached to the outlet of the cavity through a fluorocarbon-rubber O-ring. In order to protect the leads of the thermocouple with the silicon wafer substrate piece, a PFA (registered trademark) tube having an inner diameter of 2 mm is inserted in the Teflon (registered trademark) joint. The leads of the thermocouple with the silicon wafer substrate piece are inserted in the PFA (registered trademark) tube and are connected to the predetermined terminal of the 302323 pen recorder from Yokogawa Electric Corporation that is placed in the predetermined place. Thus, the influence of air in the cavity can be reduced, and the leads of the thermocouple with the silicon wafer substrate piece can be protected from external impacts and ambient atmosphere. By connecting the cavity to the ambient air through the PFA (registered trademark) tube, variations in pressure in the cavity during temperature changes can be avoided, improving safety.

If the cavity of the quartz stage has a through structure, multiple such thermocouples with the silicon wafer substrate piece can be disposed in any positions on a silicon wafer substrate so that one-dimensional measurement can be performed.
Embodiments of the present invention will be described with reference to the accompanying drawings.

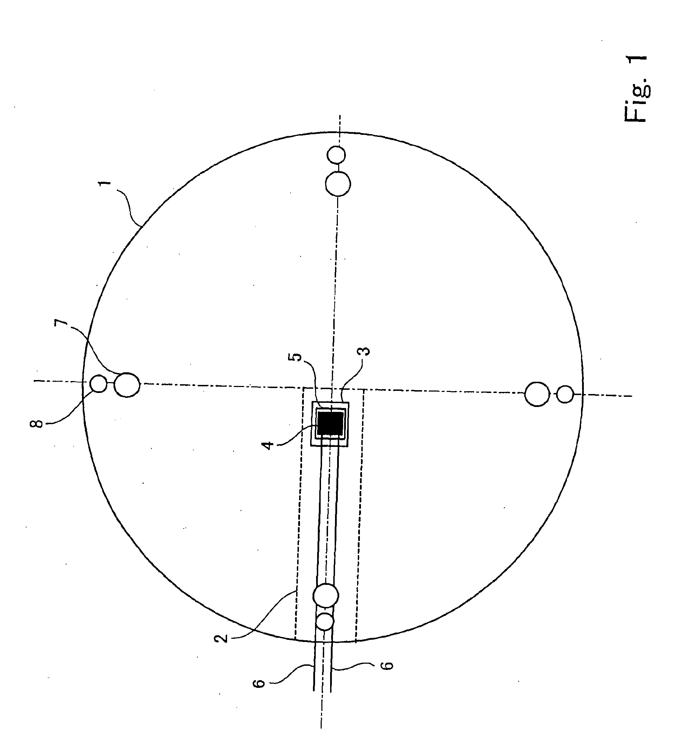

Fig. 1 is a top view of a silicon wafer substrate stage having the capability of measuring temperature according to one embodiment of the present invention. A thermocouple 4 for measuring temperature is provided inside a rectangular parallelepiped cavity 2 formed in the silicon wafer substrate stage 1 in such a manner that the thermocouple 4 faces the backside of a silicon wafer 9. A small piece 3 of the silicon wafer is provided on the backside of the thermocouple 4 through a polyimide adhesive 5. A pair of thermocouple leads 6 extending from the thermocouple 4 extend outside the silicon wafer substrate stage 1. Provided on the surface of the stage are silicon wafer supports 7 for supporting the silicon wafer 9 and silicon wafer holding notches 8 for holding the silicon wafer.

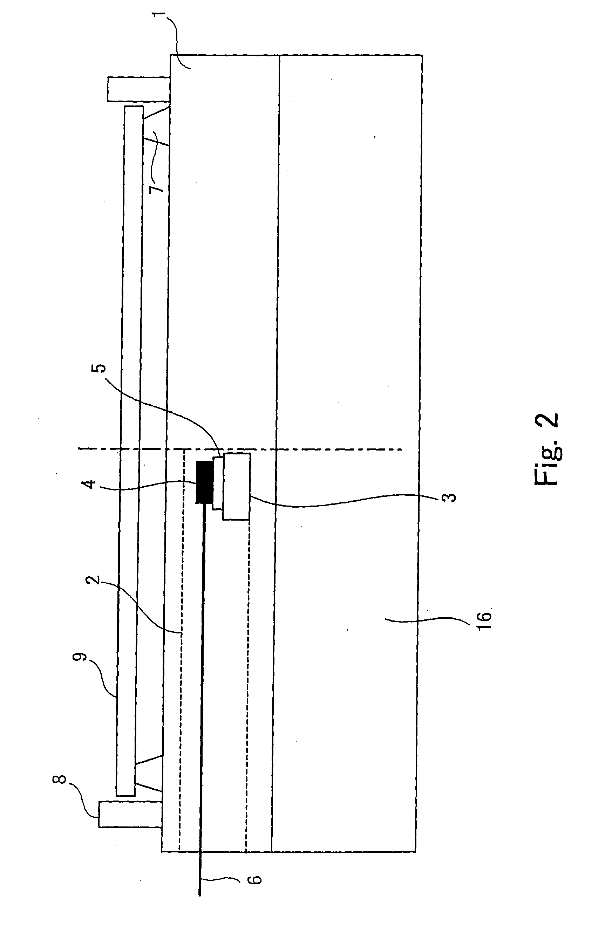

Fig. 2 is a cross-sectional view of the silicon wafer substrate stage 1 having the temperature measurement capability according to the embodiment of the present invention, taken perpendicularly to a line passing through the center of the rectangular parallelepiped cavity 2, showing the relation among the silicon wafer supports 7, which are projections supporting the silicon wafer 9, the silicon wafer holding notches 8, the silicon wafer 9, and a lamp heater 16. It can be seen that the front side of the silicon wafer piece 3 on which the thermocouple 4 is provided being in contact with the silicon wafer piece 3 faces the side opposite to the lamp heater 16. With this arrangement, a state in which the silicon wafer 9 is placed can be simulated even though there are differences in that the silicon wafer piece 3 has the same composition and thickness as those of the silicon wafer 9 and therefore substantially the same heat propagation coefficient, although the thermal capacity of the silicon wafer piece 3 is smaller than that of the silicon wafer 9 because the area of the silicon wafer piece 3 is approximately one-fiftieth of that of the silicon wafer 9 and in that the silicon wafer piece 3 is irradiated with a slightly larger amount of heat than heat reaching the silicon wafer 9 because the silicon wafer piece 3 is closer to the lamp heater 16 than the silicon wafer 9.

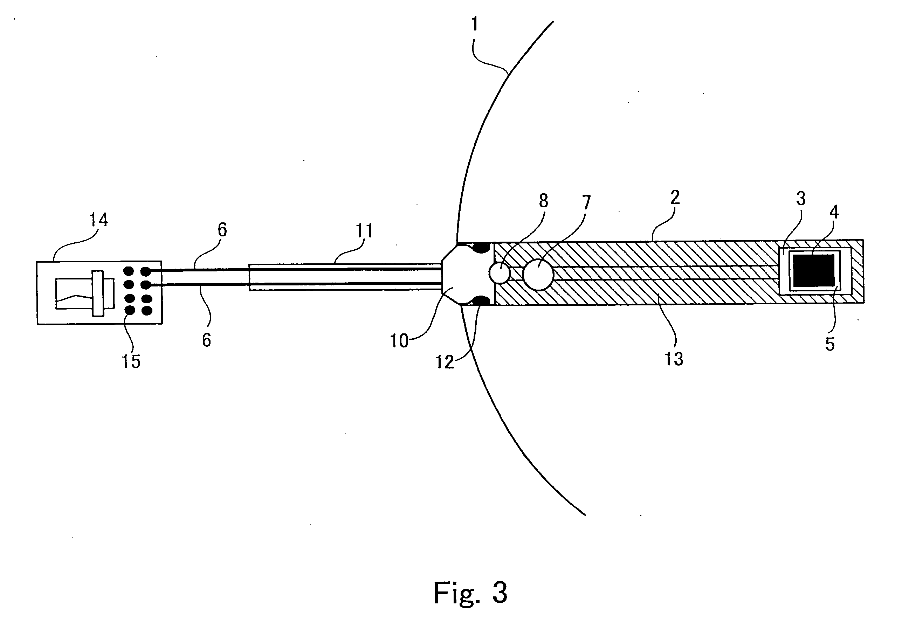

Fig. 3 is a top view of the silicon wafer substrate stage 1 having the capability of sensing temperature according to the embodiment of the present invention and is an enlarged view of the rectangular parallelepiped cavity 2 for showing an overview of connection between a PFA (registered trademark) tube 11 for protecting the thermocouple leads 6 and a Teflon (registered trademark) joint 10. The silicon wafer piece 3 bonded on the backside of the thermocouple 4 through the polyimide adhesive 5 is disposed in the cavity and the rest of the rectangular parallelepiped cavity 2 is filled with quartz wool 13. A pair of thermocouple leads 6 extending from the thermocouple 4 are guided through the PFA (registered trademark) tube 11 inserted in the Teflon (registered trademark) joint 10 tightly attached to the rectangular parallelepiped cavity 2 through an O-ring 12 to the outside of the silicon wafer substrate stage 1 and are connected to a predetermined terminal 15 of a pen recorder 14 provided in a predetermined place.

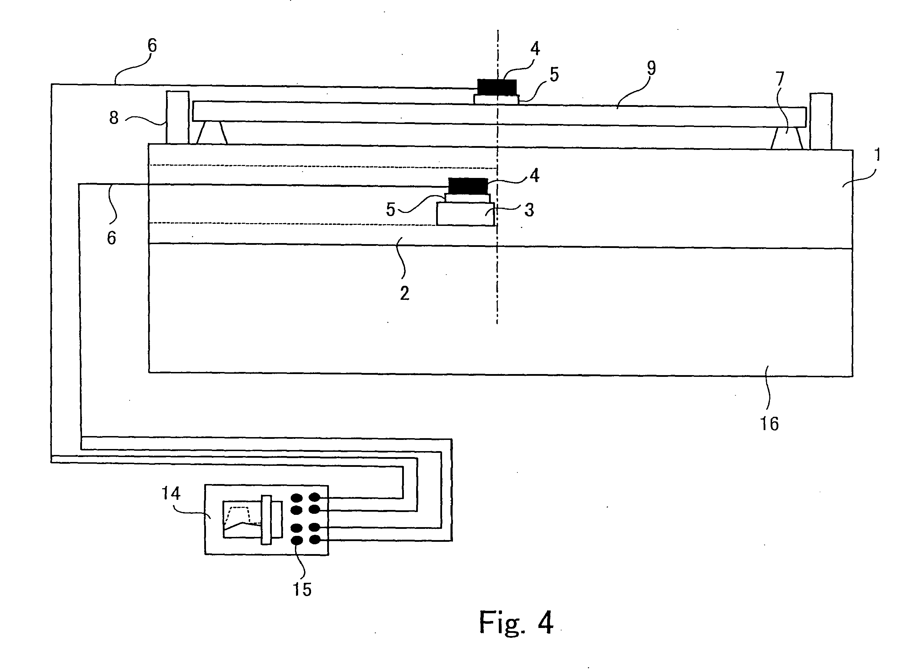

Fig. 4 is a cross-sectional view of a silicon wafer substrate stage 1 having the capability of detecting temperature according to a first embodiment of the present invention. A rectangular parallelepiped cavity 2 for containing a thermocouple 4 is provided in the silicon wafer substrate stage 1. The rectangular parallelepiped cavity 2 is characterized in that it has a length reaching the center and may be positioned in any place in the silicon wafer substrate stage 1. A silicon wafer piece 3 on which a thermocouple 4 provided being in contact with the silicon wafer piece 3 is placed near the center of the rectangular parallelepiped cavity 2. Thermocouple leads 6 are extended from the rectangular parallelepiped cavity 2 to the outside of the silicon wafer substrate stage 1 and is connected to a terminal 15 of a pen recorder 14 located in a predetermined place. A silicon wafer 9 on which a thermocouple 4 is provided concentrically with the thermocouple 4 on the silicon wafer piece 3 and fixed with a polyimide adhesive 5 is placed on silicon wafer supports 7 inside silicon wafer holders 8 on the silicon wafer substrate stage 1. The leads 6 extending from the thermocouple 4 on the silicon wafer 9 are guided to the outside of the silicon wafer substrate stage 1 and are connected to terminals 15 of the pen recorder 14 located in the predetermined place. Thus, a difference between the silicon wafer 9 and the silicon wafer piece 3 having the same composition and thickness as those of the silicon wafer 9 in temperature measurement can be corrected.

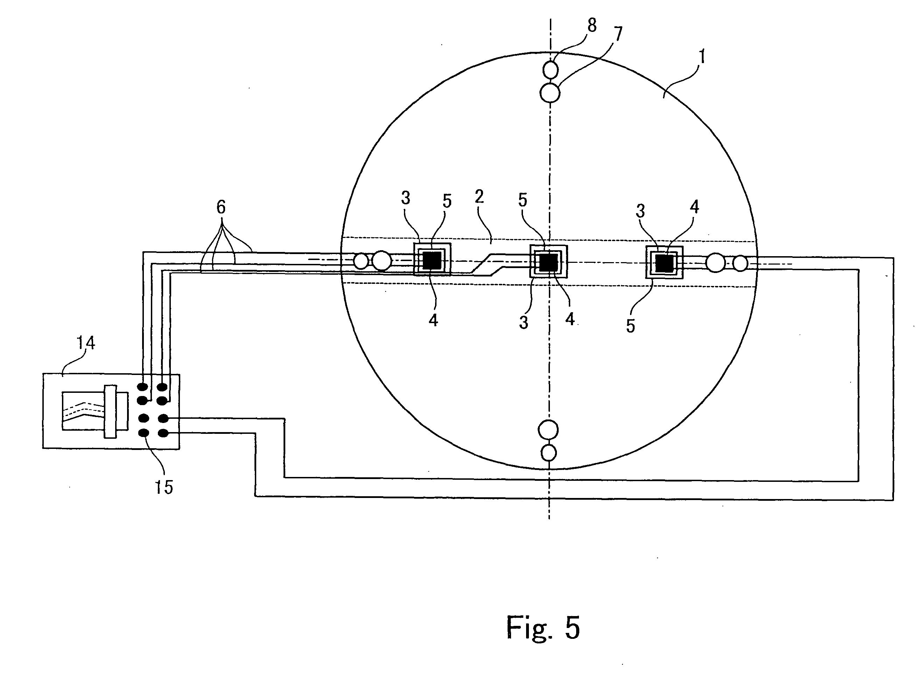

Fig. 5 shows a top view of a silicon wafer substrate stage 1 having the capability of detecting temperature according to a second embodiment of the present invention. Provided on a silicon wafer substrate stage 1 is a rectangular parallelepiped cavity 2 for containing thermocouples 4. The rectangular parallelepiped cavity 2 is characterized in passing through the stage and may be provided in any place on the silicon wafer substrate stage 1. Three thermocouples 4 are disposed evenly spaced apart in the rectangular parallelepiped cavity 2 in such a manner that one of the thermocouples 4 is placed at the center of the rectangular parallelepiped cavity 2. Thermocouple leads 6 are extended to the outside of the silicon wafer substrate stage 1 and are connected to terminals 15 of a pen recorder 14 located in a predetermined place. Thus, one-dimensional temperature information at any number of points can be obtained at a time.

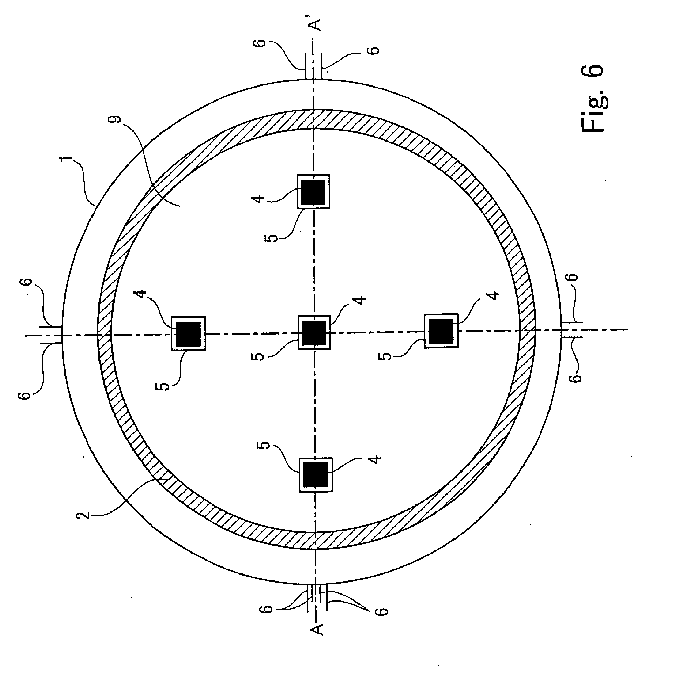

Fig. 6 is a top view of a silicon wafer substrate stage having the capability of detecting temperature according to a third embodiment of the present invention.

Five thermocouples 4 for temperature measurement are embedded in an 8-inch silicon wafer 9 and then sealed with a polyimide adhesive 5. A recess is formed for placing the silicon wafer 9 with the thermocouples 4 in contact with the silicon wafer substrate stage 1. After the silicon wafer 9 with the thermocouples 4 is brought into intimate contact with the silicon wafer substrate stage 1, the empty space in the recess is filled with the polyimide adhesive 5 to complete the stage. Two-dimensional temperature information at any number of points can be obtained at a time.

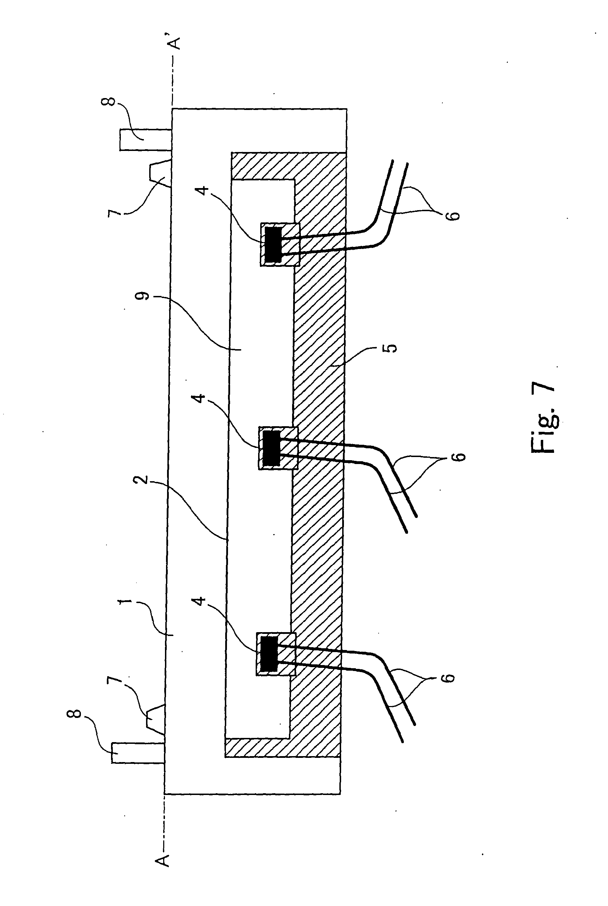

Fig. 7 is a cross-sectional view of the silicon wafer substrate stage shown 1 in Fig. 6 in which many thermocouples 4 are embedded in the silicon wafer 9 for two-dimensional temperature measurement, taken along line A - A' of Fig. 5. The relation between the silicon wafer 9 in which the thermocouples 4 are embedded and the main body of the silicon wafer substrate stage 1 can be seen.

The present invention will be described in further detail with respect to examples.

### First example

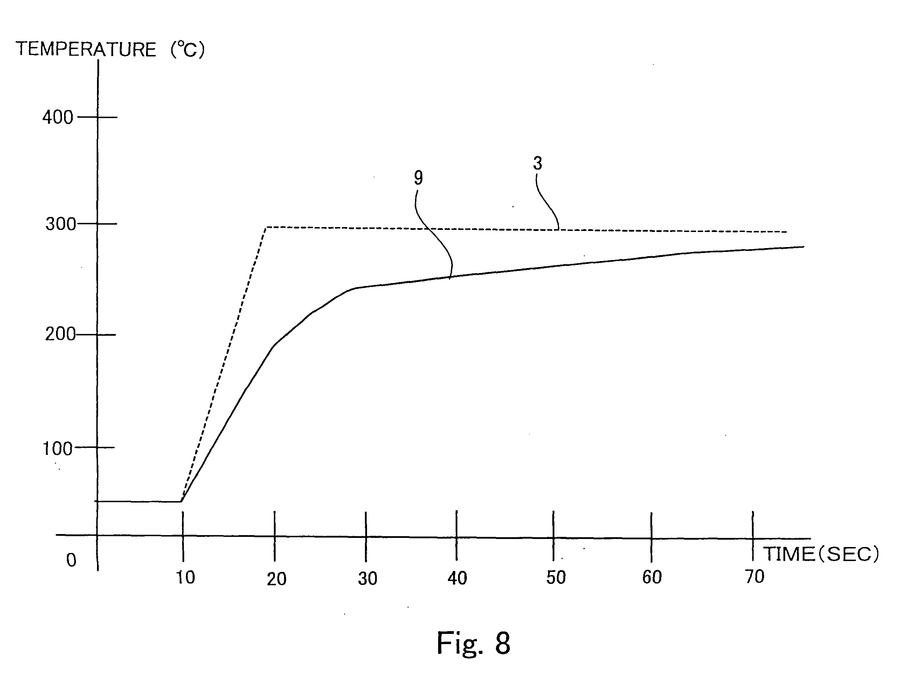

Fig. 8 shows a graph continuously plotting variations in temperature of a silicon wafer substrate 9 for 70 seconds immediately after the silicon wafer substrate 9 was placed on a silicon wafer substrate stage in order to measure the difference in temperature profile between the silicon wafer 9 and a silicon wafer piece 3 having an area that is approximately one-fiftieth the area of the silicon wafer 9 and having the same composition and thickness as those of the silicon wafer 9. The silicon wafer piece 3 that has an area that is approximately one-fiftieth the area of the silicon wafer 9 and has the same composition and thickness of those of the silicon wafer 9 and has a thermocouple provided on the front side of the silicon wafer piece 3 in contact with the silicon wafer piece 3 was placed in a cavity 2 in the center of the silicon wafer substrate stage 1 shown in Fig. 4 in such a manner that the thermocouple faces the side opposite to a lamp heater 16, and a positive resist was applied to one side of the p-type 001 surface orientation with a diameter of 8 inches to a thickness of 1 micrometer, and was dried to cure. Then, the silicon wafer 9 disposed in the center of the silicon wafer 9 in contact with the silicon wafer 9 through a polyimide adhesive 5 was placed on the silicon wafer substrate stage 1 and the temperature was raised to 300 °C and then decreased. In the plot of Fig. 8, the temperature profile of the silicon wafer piece 3 is represented by the dashed curve labeled with 3; the temperature profile of the silicon wafer 9 is represented by the solid line labeled with 9 in the plot of Fig. 8. The same measurement was performed 16 times, which demonstrated similar tendencies. It was shown that there is a correlation in temperature profile between the silicon wafer 9 and the silicon wafer piece 3 having the same composition and thickness of those of the silicon wafer 9 and having an area that is approximately one-fiftieth of the area of the silicon wafer 9 and therefore the temperature of the silicon wafer 9 can be known by measuring the temperature of the silicon wafer piece 3 having the same composition and thickness as those of the silicon wafer 9 and having an area that is one-fiftieth of the area of the silicon wafer 9.

### Second example

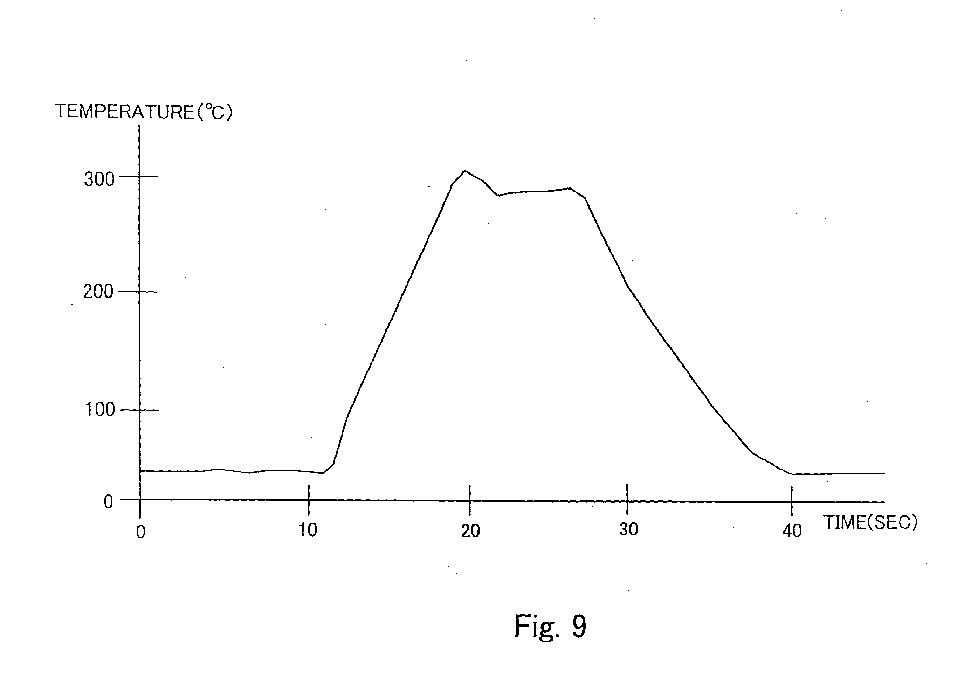

Fig. 9 is a graph plotted variations in temperature of a silicon wafer substrate 9 continuously in a period immediately after the silicon wafer 9 is placed on the silicon wafer substrate stage 1 shown in Fig. 3 by increasing the temperature to 300°C and then decreasing the temperature. The silicon wafer substrate 9 was a sample provided by applying a positive resist to a thickness of 1 micrometer on one side of a p-type 001 surface-orientation silicon wafer 9 with a diameter of 8 inches. It can be seen the temperatures can be monitored over the entire period from the temperature rise to the temperature drop. Tests on seven samples were performed to confirm the ability of detecting the temperature of silicon wafer substrate and good results were obtained in every test.

## Claims

1. A disc-shaped wafer substrate holding stage made from quartz that has a generally flat surface with a thermocouple that measures temperature of a wafer substrate in a silicon wafer heating system including a radiative heating lamp heater, comprising:
a plurality of notches that hold a single wafer substrate on the surface of the stage, the notches being made from the same material as the stage;
a plurality of supports that hold the single wafer substrate at a predetermined height from the surface of the stage, the supports being made from the same material as the holding stage; and
at least one cavity linearly extending in parallel with the surface of the stage from at least one point on a side of the stage;
wherein a small piece of wafer, which has a thermocouple disposed so as to be in contact with a front side of the small piece of wafer, and which has the same composition and thickness as the composition and thickness of the wafer substrate, and a predetermined volume ratio (area ratio) to the wafer substrate, is disposed in the cavity in such a manner that the thermocouple does not face the radiative heating lamp heater.

2. The stage according to claim 1, wherein a PFA (registered trademark) tube is provided as a protective tube for protecting a pair of leads extending from the thermocouple provided in the cavity and a Teflon (registered trademark) joint is provided in, and in contact with, the cavity through an O-ring made of fluorocarbon rubber for attaching the PFA (registered trademark) tube.

3. The stage according to claim 1, wherein the area ratio of the small piece of wafer to the wafer substrate to be measured does not exceed two-fiftieths.

4. The stage according to claim 1, wherein after the thermocouple is placed in a predetermined position in the cavity, remaining space in the cavity is filled with any one of quartz wool, Teflon (R) wool, polyimide wool, and a thermosetting resin.

5. A disc-shaped wafer substrate holding stage made from quartz that has a generally flat surface with a thermocouple that measures temperature of a wafer substrate in a silicon wafer heating system including a radiative heating lamp heater, comprising:
a plurality of notches that hold a single wafer substrate on the surface of the stage, the notches being made from the same material as the stage;
a plurality of supports that hold the single wafer substrate at a predetermined height from the surface of the stage, the supports being made from the same material as the holding stage;
wherein a recess that has a predetermined depth from a backside of the stage and a predetermined size is formed in the backside of the quartz forming the surface of the stage, a silicon wafer having at least one temperature measuring thermocouple embedded therein and sealed with a polyimide
resin is disposed in, and in contact with, the cavity, and interspace between the recess and the silicon wafer is filled with a polyimide resin.

6. A method for measuring temperature of a silicon wafer substrate using the stage according to claim 1, comprising:
disposing a thermocouple on a dummy wafer of a silicon wafer substrate to be measured placed on the surface of the stage such that the thermocouple is in contact with the dummy wafer;
a preliminary step of obtaining in advance data about a difference between a measured temperature of the thermocouple and a measured temperature of a thermocouple disposed on, and in contact with, a small piece of wafer; and
estimating the temperature of a silicon wafer substrate to be measured, from the data about the difference and a measured temperature of the thermocouple disposed on, and in contact with, the small piece of wafer.
